# EUROPEAN PATENT SPECIFICATION

(11) **EP 1 543 553 B1**
(45) Date of publication and mention of the grant of the patent: **09.02.2011**
(21) Application number: 03763890.5
(22) Date of filing: 16.07.2003
(51) Int. Cl.: H01L 21/762, H01L 21/20, H01L 21/18, H01L 21/304

(54) **A LAYER TRANSFER METHOD**
SCHICHTENTRANSFERVERFAHREN
PROCEDE DE TRANSFERT DE COUCHE

(30) Priority: 17.07.2002 FR 0209018
(43) Date of publication of application: 22.06.2005
(73) Proprietor: S.O.I.Tec Silicon on Insulator Technologies, 38190 Bernin (FR); Commissariat à l'Énergie Atomique et aux Énergies Alternatives, 75015 Paris (FR)
(72) Inventor: ASPAR, Bernard, F-38140 Rives (FR); BRESSOT, Séverine, F-38210 La Rivière (FR); RAYSSAC, Olivier, F-38100 Grenoble (FR)
(74) Representative: Bomer, Françoise Marie
(86) International application number: PCT/EP2003/007853
(87) International publication number: WO 2004/008526

(56) References cited:
- EP-A- 1 061 566
- EP-A1- 0 977 252
- WO-A2-03/081664
- FR-A- 2 811 807
- US-A1- 2002 081 822
- US-B1- 6 406 636

## Description

The present invention relates to an improved method for transferring a layer of material from a source substrate onto a support substrate during the fabrication of composite substrates, in particular for optics, optoelectronics, or electronics.

Novel techniques have recently been developed for transferring a layer of a material, in particular an optionally processed semiconductor material, from a first or "source" substrate onto a second or "support" substrate.

The term "processed layer" designates a layer of material that has undergone some or all of the steps of a technical method for forming electronic components.

Said transfer techniques use as the source substrate a substrate that has been weakened by implanting atomic species, a substrate having a buried porous zone, or a substrate with two layers bonded to each other by means of a bonding interface with controlled bonding energy.

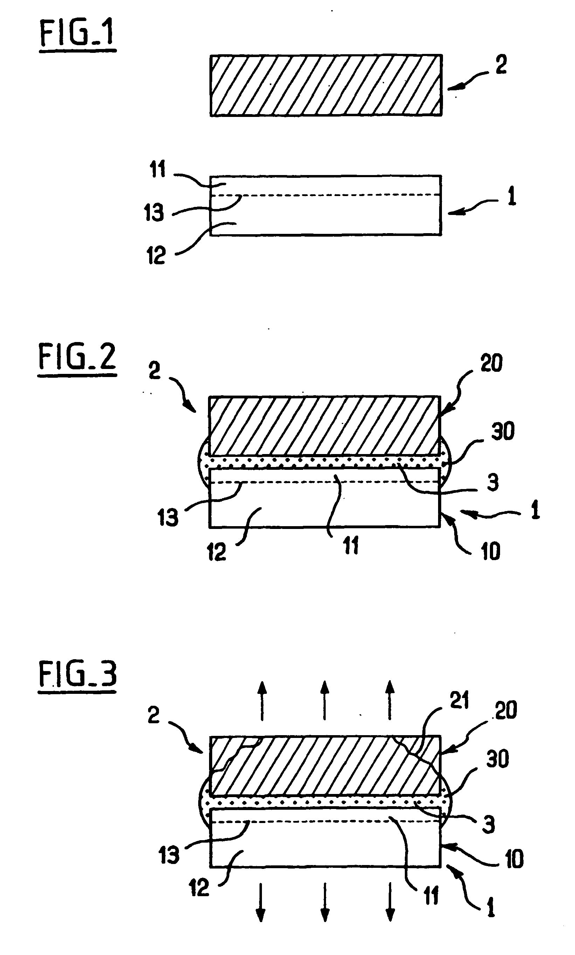

Said techniques are described briefly below with reference to the accompanying Figures 1 to 3.

The source substrate 1, weakened by one of the techniques mentioned above, is brought into contact with a support substrate 2 so as to form a stack, then the layer to be transferred 11 is detached from the remainder 12 of the source substrate along the zone of weakness 13 of said substrate, for example by stresses of mechanical origin.

Said stresses of mechanical origin are generally tension and/or bending and/or shear stresses.

They can be applied, for example, by a pulling rig, a blade such as a guillotine introduced to the side of said stack, at the zone of weakness 13, or by a jet of fluid (liquid or gas) applied laterally at said zone of weakness.

Application of said mechanical stresses encourages the propagation of a crack at the zone of weakness 13.

When the two substrates 1 and 2 are applied one against each other by molecular bonding, i.e., without using adhesive or an adhesive film, transfer of the layer to be transferred 11 is possible providing the mechanical retention of said layer 11 on the source substrate 1 is well below the mechanical retention of said layer 11 on the support substrate 2.

However, that condition is no longer satisfied if adhesive is used since the exact volume of adhesive deposited is difficult to control. As can be seen in Figure 2, the adhesive 3 very often projects out at 30 beyond the respective side faces 10, 20 (or sides) of substrates 1, 2 so that the periphery of the zone of weakness 13 opening into the side face 10 of the source substrate 1 is masked.

It is then very difficult to detach the layer to be transferred 11 properly by applying mechanical stresses.

The mechanical force to be applied becomes very high, which may result in cleavage of the substrates and in particular of the support substrate 2 along fracture lines 21 which no longer extend in the plane of the zone of weakness 13, but in a, random and unpredictable manner in the thickness of said substrate 2 (see Figure 3).

The document EP-0 977 252 describes a process for selectively transferring semiconductor chips from an initial substrate to a reception support or handle. In order to do this, the initial substrate surface on which the chips are made is prepared to enable hydrophilic bonding with a controlled bonding energy.

This surface preparation may include the deposit of a layer in which chips are embedded. Then, the handle is applied on said additional layer and the chips are transferred thereon.

Nevertheless, this embedding layer is not an adhesive and will not project out on the side faces of the substrates.

Consequently, the process disclosed in this document will not allow to resolve the above-mentioned problem.

Finally, the document WO-03/081664 concerns a method for transferring electronical components between a source substrate and a target substrate, for example by using glue.

This document does not describe the possibility to have an excess of glue, nor the related problems of overflowing of this glue on the sides of the substrates.

The aim of the present invention is to overcome those disadvantages, and in particular to improve mechanical layer transfer methods, and to prevent excess material deposited at the bonding interface between a source substrate and a support substrate from masking the attack edge of the zone of weakness.

This aim is accomplished by a method of transferring a layer of material from a source substrate onto a support substrate, to fabricate a composite substrate for applications in the fields of electronics, optics, or optoelectronics, said source substrate having a zone of weakness interposed between the layer of material to be transferred and the remainder of said source substrate, said method comprising at least the steps consisting in: +
- forming at least one recess in at least one of the two substrates, said recess opening onto one of the faces termed the "front face" of the source substrate or onto one of the faces termed "the front face" of the support substrate in which it is formed, the depth of the recess, when it is formed in the source substrate, being at least equal to the depth at which the zone of weakness is located;
- depositing an adhesive or adhesive compound onto the front face of the source substrate or onto the front face of the support substrate or onto both said faces, said recess (es) receiving excess adhesive or excess adhesive compound and preventing it to mask the periphery of sai zone of weakness opening into the side face of the source substrate;
- applying said source substrate and said support substrate against each other, their respective front faces facing one another; and
- detaching said layer to be transferred from the remainder of the source substrate, along the zone of weakness, by applying a stress of mechanical origin;

According to the invention, the adhesive or adhesive compound is chosen among an epoxy adhesive, a cyanoacrylate adhesive, polyimides wax, spin on glass (SOG) product.

Non-limiting, advantageous characteristics of the invention, taken alone or in combination, are as follows:
- said recess communicates with the rear face of the substrate in which it is formed;
- the recess is in the form of an annular groove opening onto the front face of the substrate in which it is formed;
- the recess can be produced by wet etching, dry etching or mechanical machining using a saw or a laser beam;
- the zone of weakness is formed by atomic species implantation, or it is formed by a porous layer or by a releasable bonding interface;
- the recess provided in the source substrate is produced prior to the step of implanting atomic species;
- the layer to be transferred is constituted by a semiconductor material;
- the additional material is an adhesive or an adhesive material.

Other characteristics and advantages of the invention become apparent from the following description of a preferred implementation of the invention. This description is made with reference to the accompanying drawings in which:
- Figures 1 to 3 are diagrams illustrating the various steps of a prior art method of transferring a layer;
- Figures 4 to 7 are diagrams illustrating the various steps of a first implementation of the layer transfer method of the invention;
- Figures 8 to 11 are diagrams illustrating the various steps of a variant of the first implementation of the method shown in Figures 4 to 7; and
- Figure 12 is a diagram illustrating a step in a second implementation of the layer transfer method of the invention.

These figures are diagrams in which the various layers, their thicknesses, or the recesses formed therein are not shown to scale since the features which are to be described in more detail have deliberately been enlarged for the purposes of clarification.

In the remainder of the description, the various substrates described are considered to be in the shape of a disk or a cylinder since that is the shape most frequently encountered. However, that feature is not limiting and said substrates could have other shapes.

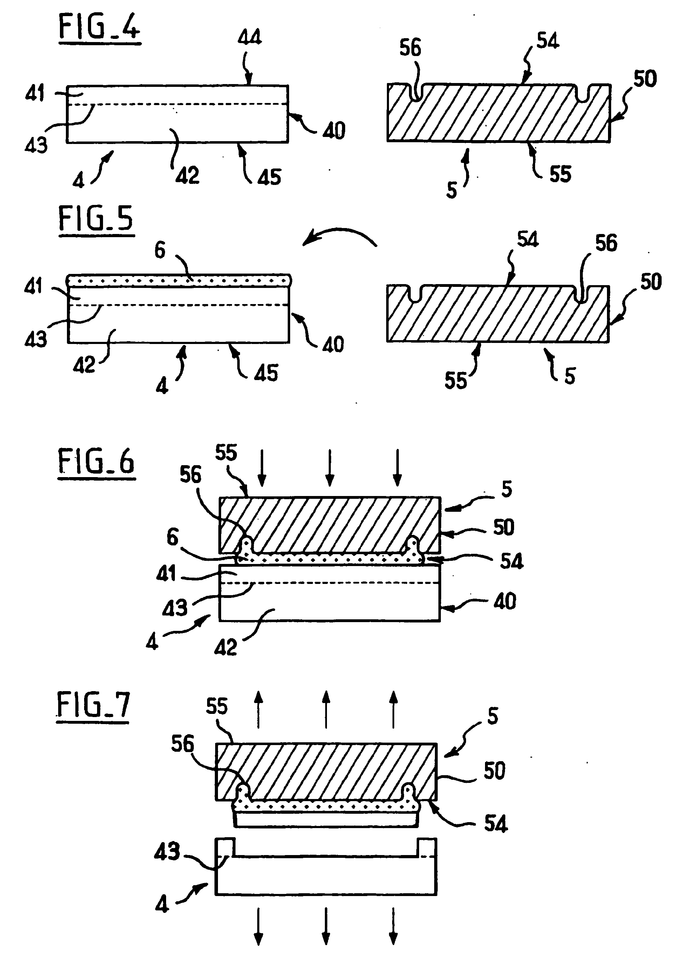

The invention falls within the category of methods of transferring a layer of material 41 deriving from a source substrate 4 onto a support substrate 5 during the fabrication of a composite substrate for applications in the fields of electronics, optics, and optoelectronics (see Figure 4). The term "composite" means that said substrate has a plurality of layers.

In the remainder of the description and claims, the terms "source substrate" and "support substrate" should be interpreted as encompassing both a singular substrate of a given material and a stack of layers of materials which may be of different kinds.

The source substrate 4 has a cylindrical side face 40, a face 44 termed the "front face" and an opposite face 45 termed the "rear face".

Further, said source substrate 4 has an internal zone 43 termed the "zone of weakness".

The term "zone of weakness" generally designates a weak zone of the source substrate 4 along which the two layers located either side thereof will subsequently detach more easily from each other.

The zone of weakness 43 can, for example, be a zone obtained by implanting atomic species in the source substrate 4. In this case, said zone 43 is interposed between a layer of material 41 which will subsequently be transferred and the remainder 42 of said source substrate, said layer 41 and the remainder 42 being formed of the same material. The layer to be transferred 41 extends between said front face 44 and the zone of weakness 43.

When the zone of weakness 43 is obtained by implanting atomic species, implantation is carried out from the front face 44 of the source substrate 4.

The term "implanting atomic species" means any bombardment of atomic, molecular, or ionic species that is capable of introducing said species into a material at a certain depth with respect to the bombarded surface 44, with a concentration maximum of said species at said depth, the depth being determined by the implantation energy of said species.

Atomic species can be implanted in said source substrate 4 using an ion beam implanter or a plasma immersion implanter, for example.

Preferably, said implantation is accomplished by ionic bombardment. Preferably, the implanted ionic species is hydrogen. Other ionic species can advantageously be used alone or in combination with hydrogen, for example rare gases (for example helium).

By way of example, reference can be made to the literature concerning the method known under the trade name "Smart Cut".

The zone of weakness 43 can also be constituted by a porous layer obtained, for example, using the method known under the trade name "ELTRAN" filed by Canon, described in European patent EP-A-0 849 788.

In this case, the source substrate 4 is constituted by a stack of layers comprising at least one layer of material 41 obtained by epitaxial growth on a porous layer 43, which layer rests on the remainder 42 of the source substrate, the term "remainder" then designating a single layer of material.

The zone of weakness 43 can also be constituted by a "releasable" bonding interface interposed between the layer 41 to be transferred and the remainder 42 constituted by one or more layers. The term "releasable" means that bonding is not definitive so that the layer 41 can subsequently be disassembled from the remainder 42.

In a manner similar to that described above for the source substrate 4, the support substrate 5 has a cylindrical side face 50, a front face 54, and a rear face 55.

Said support substrate 5 acts to hold the assembly together mechanically.

The source substrate 4 and the support substrate 5 are intended to be applied against each other in the subsequent steps of the method by their respective front faces 44 and 54.

In accordance with the invention, prior to depositing the material with reference number 6 as is described below, at least one recess opening onto the front face of at least one of the two substrates 4 and 5 (or both) is formed in said face (or faces) .

As shown in the figures, this recess is intended to collect the excess material 6 deposited between the respective front faces 44, 54 of the two substrates 4 and 5.

In the first implementation of the invention shown in Figures 4 to 7, this recess is formed in the support substrate 5 and opens out into the front face 54. In this case, it has reference number 56.

Said recess 56 can be of any shape. Advantageously, it is in the shape of an annular groove located close to the periphery of the substrate 5.

The dimensions of said recess 56, i.e., its width, its length and its depth, are selected by the skilled person in a suitable manner as a function of the excess volume of material 6 that it is desired for it to be able to receive.

Said recess 56 creates a buffer space which can collect any excess material 6 due, for example to the fact that the volume of additional material 6 is not reproducible from one substrate to another. The volume of the recess 56 will thus generally correspond to about 10% to 20% of the total volume of additional material 6.

Further, in methods in which a constant volume of material 6 is deposited (using a syringe, for example), the invention makes it possible to introduce successive substrates with diameters that vary slightly into the fabrication facility without having to modify the volume of material 6 deposited.

Said recess 56 can be formed in a variety of manners and in particular by methods known as "cold methods", i.e., carried out at a temperature of less than about 400°C, or by methods known as "hot methods", i.e., methods involving heating the substrate to temperatures of more than 400°C, but with said heating being localized to the region in which etching is being carried out.

Cold methods include wet etching and dry etching.

Wet etching consists of applying a mask to the front face 54 of the support substrate 5. The mask, obtained by photolithography, reproduces the pattern of the recess 56 which is to be produced. By way of example, the mask can be produced using a photosensitive resin, a layer of silicon dioxide (SiO₂), or a layer of silicon nitride (Si₃N₄).

The prepared substrate is then immersed in an etching solution constituted by a suitable chemical solution kept at a temperature of close to 70°C, while protecting the rear face 55 of said support substrate 5.

This etching solution selectively attacks the unprotected portion of the front face 54 and etches the recess 56. The time during which the substrate 5 is left in contact with said etching solution determines the etching depth.

By way of example, when etching silicon and the mask is formed from SiO₂ or Si₃N₄, either potassium hydroxide (KOH) or tetramethyl hydroxylamine (TMAH) can be used as the etching solution. Said two chemical solutions exhibit very great selectivity between silicon and SiO₂ or Si₃N₄.

Following etching, the mask must be removed. As an example, it is possible to use a solvent when the mask is based on a resin, or to use a solution of hydrofluoric acid (HF) for a SiO₂ mask, or to use phosphoric acid (H₃PO₄) at 180°C for a Si₃N₄ mask.

Dry etching is also carried out through a mask applied to the front face 54 of the substrate 5. Said mask can be produced as described for wet etching.

Dry etching is then carried out by ionic bombardment, which combines the ballistic action of ions with their chemical action.

One example of a method used for dry etching is the method known under the acronym "RIE" for "reactive ion etching," . The chemical compounds used for said bombardment depend strongly on the chemical nature of the layer to be etched. As an example, silicon is etched with sulfur hexafluoride SF₆, silicon carbide with a mixture of sulfur hexafluoride and oxygen (SF₆/O₂), silicon oxide with a mixture of sulfur hexafluoride and oxygen (SF₆/O₂) or with a mixture of trifluoromethane and sulfur hexafluoride (CHF₃/SF₆), and silicon nitride is etched using a trifluoromethane/oxygen/sulfur hexafluoride mixture (CHF₃/O₂/SF₆).

The etching produced can vary as a function of the different parameters employed, such as the applied voltage or the pressure inside the vessel in which said method is carried out.

In contrast to wet etching, it is not necessary to protect the rear face of the substrate prior to etching. This concerns monoface etching.

The mask used is then removed as described above for wet etching.

Hot methods are constituted by mechanical machining carried out, for example, using a saw or a laser. The advantage of this type of technique is that there is no need to protect either the front face or the rear face of the substrate.

Mechanical machining can be carried out using a saw, e.g. of silicon carbide, which can produce grooves of about 100 micrometers (µm).

Machining can also be carried out using a laser beam, which heats the material until it melts. This technique allows machining to be automated and allows a series of cut segments to be formed. However, the molten material often tends to re-deposit itself on the sides, forming beads which then have to be removed by chemical attack. Thus, the active zones should be protected.

After the recess 56 has been formed, material 6 is deposited either on the front face 44 of the source substrate 4 (as shown in Figure 5), or on the front face 54 of the support substrate 5, or on both front faces. Clearly, in the second and third cases, deposition on the front face 54 is carried out after the recess 56 has been formed.

This material 6 is an adhesive (an epoxy adhesive or a cyanoacrylate adhesive) or an adhesive compound, i.e., a liquid or solid compound that can be applied to or deposited onto substrates 4 or 5 to allow them to adhere to each other. Such adhesive compounds are chosen among polyimides, wax or the product known as "SOG" (spin on glass), i.e., a liquid oxide deposited by centrifuging.

The two substrates are then applied to each other so that said layer of material 6 is interposed between their respective front faces 44 and 54 and the two substrates 4 and 5 are pressed against each other (see Figure 6). This causes any excess material 6 to penetrate into the recess 56, preventing the material 6 from projecting in the direction of the side faces 40 and 50.

Finally, the layer to be transferred 41 is detached from the remainder 42 of the source substrate 4 along the zone of weakness 43, by applying a stress of mechanical origin (see Figure 7).

Said stress is a tension and/or bending and/or shear stress, for example.

This stress can be applied, for example, by a pulling rig, a blade such as a guillotine introduced into the side face 40 of the source substrate 4 at the zone of weakness 43, or by a jet of fluid (liquid or gas) applied laterally to the same interface.

By way of example, reference can be made to French patent FR-A-2 796 491 and to European patent EP-A-0 849 788, which describe methods of detaching two layers using a jet of gas (air) and a jet of liquid (water) respectively.

Detachment takes place horizontally along the zone of weakness 43 and vertically, perpendicular to or substantially perpendicular to the outer limit of the layer of material 6.

In a second variant of the method of the invention, it is also possible to form the recess for receiving the excess of material 6 on the front face 44 of the source substrate 4.

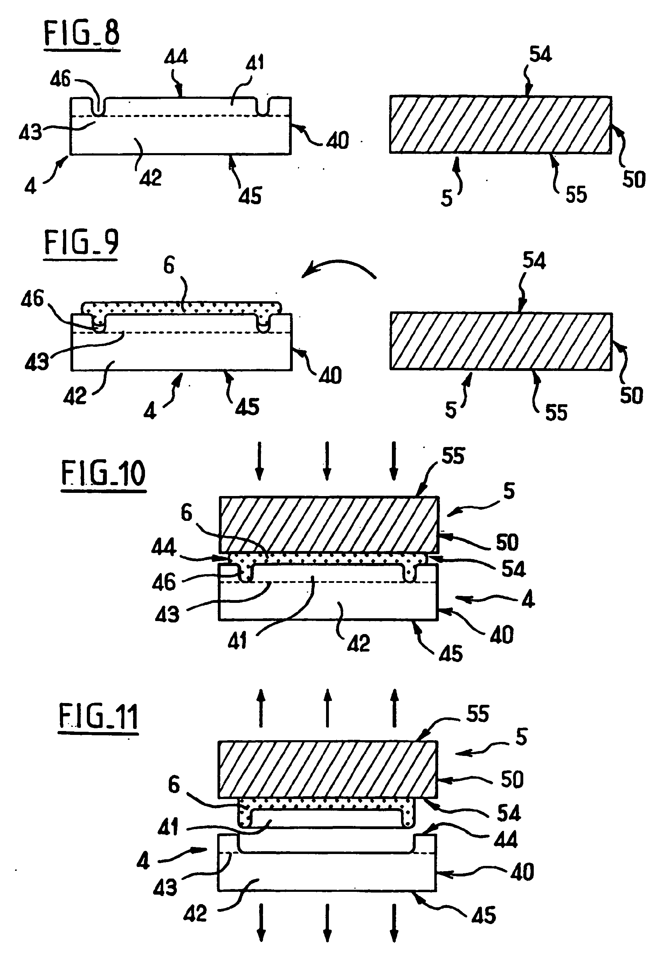

This recess then carries the reference number 46 and the corresponding method is illustrated in Figures 8 to 11. Apart from the position of the recess, the successive steps of the method shown in said figures are similar to those of Figures 4 to 7, and their description will not be recapped here in detail.

However, in this particular case, a laser is not be used to form the recess 46 since metallic layers, for example, or a weakened layer obtained by a method of implanting atomic species risk being incapable of tolerating the localized heating caused by the laser.

Further, if the machining is carried out by a hot method (mechanical machining) and if the zone of weakness 43 is obtained by implanting atomic species, then said recess 46 will be formed prior to the atomic species implantation step to prevent localized elevation in the temperature causing the layer 41 to detach from the remainder 42 of substrate 4.

Further, when the front face 44 is a "processed" surface, etching is carried out in the cut paths (inactive zones on the front face 44) to limit the loss of surface area.

Further, it should be noted that the depth of recess 46 is at least equal to the depth at which the zone of weakness 43 is located (which corresponds to the thickness of the layer to be transferred 41).

Finally, it is also possible simultaneously to provide recesses 46 and 56 on the two front faces of substrates 4 and 6 respectively. This further increases the volume available to collect the excess of material 6.

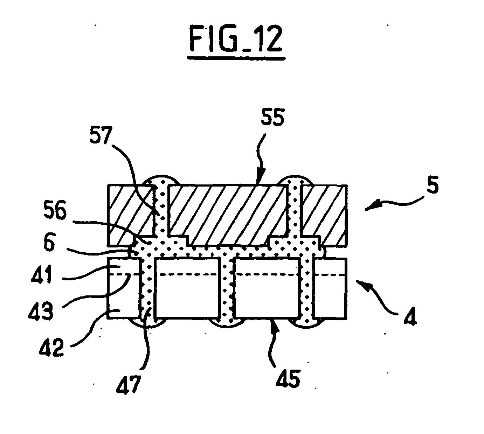

Figure 12 shows a second embodiment of the recess for receiving an excess of material 6. In this figure, the source substrate 4 and the support substrate 5 are shown applied against each other.

In this embodiment, the recess formed in one substrate communicates with the rear face thereof via a channel.

To simplify the diagrams, a first variant of said channel is arbitrarily selected to be shown on the support substrate 5 and a second variant on the source substrate 4, although the reverse is also possible.

In the first variant, recess 56, which may have any shape opening onto the front face 54, communicates with the rear face 55 of substrate 5 via a channel 57 connecting any point of its base to said rear face.

In the second variant, the recess is simply constituted by a channel 47 passing through the source substrate 4 from one side to the other.

As mentioned above, it is also possible simultaneously to produce the recesses and channels in the source substrate 4 and in the support substrate 5 which are applied against each other.

Said channels 47, 57 are formed using the same techniques used for forming recesses 46, 56 and preferably using wet or dry etching techniques, which result in deeper etching.

Such a channel 47 or 57 allows the excess of material 6 to be evacuated from the rear faces 45, 55 of the substrates. Since the channel is open to the outside, it allows greater variation in the volume of applied material 6.

This method is applicable to substrates 4, 5 of a variety of materials, in particular semiconductors, used in the fields of optics, electronics, and optoelectronics.

Examples that can be cited are silicon, germanium, silicon carbide (SiC), or III-V materials, i.e., compounds one of the elements of which is to be found in column IIIa of the periodic table and the other element of which is to be found in column Va, for example gallium arsenide (GaAs), or indium phosphide (InP).

## Claims

1. A method for transferring a layer of material (41) from a source substrate (4) onto a support substrate (5) to fabricate a composite substrate for applications in the fields of electronics, optics, or optoelectronics, said source substrate (4) having a zone of weakness (43) interposed between the layer of material to be transferred (41) and the remainder (42) of said source substrate, said method comprising at least the steps consisting in:
- forming at least one recess (46, 47, 56, 57) in at least one of the two substrates (4, 5), said recess opening onto one of the faces (44) termed the "front face" of the source substrate (4) or onto one of the faces (54) termed "the front face" of the support substrate (5) in which it is formed, the depth of the recess (46, 47), when it is formed in the source substrate (4), being at least equal to the depth at which the zone of weakness (43) is located;
- depositing an adhesive or adhesive compound (6) onto the front face (44) of the source substrate (4) or onto the front face (54) of the support substrate (5) or onto both said faces, said recess (es) receiving excess adhesive or excess adhesive compound (6) and preventing it to mask the periphery of said zone of weakness (43) opening into the side face (10) of the source substrate;
- applying said source substrate (4) and said support substrate (5) against each other, their respective front faces (44, 54) facing one another; and
- detaching said layer to be transferred (41) from the remainder (42) of the source substrate (4), along the zone of weakness (43), by applying a stress of mechanical origin;
**characterized in that** the adhesive or adhesive compound (6) is chosen among an epoxy adhesive, a cyanoacrylate adhesive, polyimides, wax, spin on glass (SOG) product.

2. A method according to claim 1, **characterized in that** said recess (46, 47; 56, 57) communicates with the rear face (45, 55) of the substrate (4, 5) in which it is Formed.

3. A method according to claim 1, **characterized in that** the recess (46, 56) is in the form of an annular groove opening onto the front face (44, 54) of the substrate (4, 5) in which it is formed.

4. A method according to any preceding claim, **characterized in that** the recess (46, 47; 56, 57) is produced by wet etching.

5. A method according to any one of claims 1 to 3, **characterized in that** the recess (46, 47; 56, 57) is produced by dry etching.

6. A method according to any one of claims 1 to 3, **characterized in that** the recess (46, 47; 56, 57) is produced by mechanical machining using a saw or a laser beam.

7. A method according to any preceding claim, **characterized in that** the zone of weakness (43) is formed by implanting atomic species.

8. A method according to any one of claims 1 to 6, **characterized in that** the zone of weakness (43) is formed by a porous layer.

9. A method according to any one of claims 1 to 6, **characterized in that** the zone of weakness (43) is formed by a releasable bonding interface.

10. A method according to claim 6 and claim 7, **characterized in that** the recess (46, 47) provided in the source substrate (4) is produced prior to the atomic species implantation step.

11. A method according to any one of the preceding claims, **characterized in that** the layer to be transferred (41) is constituted by a semiconductor material.

## Patentansprüche

1. verfahren zum Übertragen einer Materialschicht (41) von einem Quellsubstrat (4) auf ein Trägersubstrat (5) zur Herstellung eines zusammengesetzten Substrats für Anwendungen in den Bereichen der Elektronik, Optik oder Optoelektronik, wobei das Quellsubstrat (4) eine Schwächezone (43) hat, die zwischen der zu übertragenden Materialschicht (41) und dem Rest (42) des Quellsubstrats angeordnet ist, wobei das Verfahren wenigstens die folgenden Schritte umfasst:
- Ausbilden wenigstens einer Aussparung (46, 47, 56, 57) in wenigstens einem der beiden Substrate (4, 5), wobei die Aussparung sich in dem Substrat, in dem sie ausgebildet wird, zu einer der Flächen (44) des Quellsubstrats (4), die als "Vorderfläche" bezeichnet wird, oder zu einer der Flächen (54) des Trägersubstrat (5), die als "Vorderfläche" bezeichnet wird, öffnet, wobei die Tiefe der Aussparung (46, 47), wenn sie im Quellsubstrat (4) ausgebildet wird, wenigstens gleich der Tiefe ist, bei der die Schwächezone (43) sich befindet;
- Auftragen eines Klebstoffs oder einer hebenden Verbindung (6) auf die Vorderfläche (44) des Quellsubstrats (4) oder auf die Vorderfläche (54) des Trägersubstrat (5) oder auf beide Flächen, wobei die Aussparung(en) überschüssigen Klebstoff oder die überschüssige klebende Verbindung (6) aufnehmen und diesen oder diese daran hindern, den Rand der Schwächezone (43), die sich zu der Seitenfläche (10) des Quellsubstrats hin öffnet, zu maskieren;
- Zusammensetzen des Quellsubstrats (4) und des Trägersubstrats (5), wobei deren jeweilige Vorderflächen (44, 54) einander zugewandt sind; und
- Ablösen der zu übertragenden Schicht (41) vom Rest (42) des Quellsubstrats (4) entlang der Schwächezone (43) durch Anwendung einer Beanspruchung mechanischen Ursprungs;
**dadurch gekennzeichnet, dass** der klebstoff oder die klebende Verbindung (6) unter den Folgenden ausgewählt werden: einem Epoxidklebsfoff, einem Cyanoacrylatklestoff, Polyimide, Wachs, einem Spin-on-Glass (SOG) Produkt.

2. Verfahren nach Anspruch 1, **dadurch gekennzeichnet, dass** die Aussparung (46, 47; 56, 57) mit der Rückfläche (45, 55) des Substrats (4, 5) in dem sie ausgebildet ist, in Verbindung steht.

3. Verfahren nach Anspruch 1, **dadurch gekennzeichnet, dass** die Aussparung (46, 56) die Form einer ringförmigen Rille hat, die sich zur Vorderfläche (44, 54) des Substrats (4, 5), in der sie ausgebildet ist, öffnet.

4. Verfahren nach einem der vorhergehenden Ansprüche, **dadurch gekennzeichnet, dass** die Aussparung (46, 47, 56, 57) durch Nassätzen erzeugt wird.

5. Verfahren nach einem der Ansprüche 1 bis 3, **dadurch gekennzeichnet, dass** die Aussparung (46, 47, 56, 57) durch Trockenätzen erzeugt wird.

6. Verfahren nach einem der Ansprüche 1 bis 3, **dadurch gekennzeichnet, dass** die Aussparung (46, 47; 56, 57) durch mechanische Bearbeitung unter Verwendung einer Säge oder eines Laserstrahls erzeugt wird.

7. Verfahren nach einem der vorhergehenden Ansprüche, **dadurch** gekenntzeichnet, dass die Schwächezone (43) durch Implantation von Atomsorten ausgebildet wird.

8. Verfahren nach einem der Ansprüche 1 bis 6, **dadurch gekennzeichnet, dass** die Schwächezone (43) durch eine poröse Schicht gebildet wird.

9. Verfahren nach einem der Ansprüche 1 bis 6, **dadurch gekennzeichnet, dass** die Schwächezone (43) durch eine auflösbare Bondinggrenzfläche gebildet wird.

10. Verfahren nach Anspruch 6 und Anspruch 7, **dadurch gekennzeichnet, dass** die im Quellsubstrat (4) ausgeführte Aussparung (46, 47) vor dem Schritt der Implantation von Atomsorten hergestellt wird.

11. Verfahren nach einem der vorhergehenden Ansprüche, **dadurch gekennzeichnet, dass** die zu übertragende Schicht (41) aus einem Halbleitermaterial besteht.

## Revendications

1. Procédé de transfert d'une couche de matériau (41) d'un substrat source (4) sur un substrat support (5) pour fabriquer un substrat composite pour des applications dans les domaines de l'électronique, de l'optique ou de l'optoélectronique, ledit substrat source (4) présentant une zone de fragilisation (43) interposée entre la couche de matériau à transférer (41) et le reste (42) dudit substrat source, ledit procédé comprenant au moins les étapes consistant à :
- former au moins un évidement (46, 47 ; 56, 57) dans au moins l'un des deux substrats (4, 5), ledit évidement débouchant sur l'une des faces (44) dite « face avant » du substrat source (4) ou sur l'une des faces (54) dite « face avant » du substrat support (5) dans lequel il est formé, la profondeur de l'évidement (46, 47), lorsqu'il est formé dans le substrat source (4), étant au moins égale à la profondeur à laquelle la zone de fragilisation (43) est située ;
- déposer un adhésif, ou un composé adhésif (6) sur la face avant (44) du substrat source (4) ou sur la face avant (54) du substrat support (5) ou sur les deux dites faces, ledit ou lesdits évidements recevant l'adhésif excédentaire, ou le composé adhésif excédentaire (6) et l'empêchant de masquer la périphérie de ladite zone de fragilisation (43) débouchant dans la face latérale (10) du substrat source ;
- appliquer ledit substrat source (4) et ledit substrat support (5) l'un contre l'autre, leurs faces avant (44, 54) respectives se faisant face ; et
- détacher ladite couche à transférer (41) du reste (42) du substrat source (4) , le long de la zone de fragilisation (43), par l'application d'une contrainte d'origine mécanisme ;
**caractérisé en ce que** l'adhésif ou le composé adhésif (6) est choisi parmi une colle époxyde, une colle cyano-acrylate, des polyimides, de la cire, un produit SOG (Spin On Glass).

2. Procédé selon la revendication 1, **caractérise en ce que** ledit évidement (46, 47 ; 56, 57) communique avec la face arrière (45, 55) du substrat (45) dans lequel il est formé.

3. Procédé selon la revendication 1, **caractérise en ce que** l'évidement (46, 56) a la forme d'une gorge annulaire débouchant sur la face avant (44, 54) du substrat (4, 5) dans lequel il est formé.

4. Procédé selon l'une quelconque des revendications précédentes, **caractérisé en ce que** l'évidement (46, 47 ; 56, 57) est réalisé par gravure humide.

5. Procédé selon l'une quelconque des revendications 1 à 3, **caractérisé en ce que** l'évidement (46, 47 ; 56, 57) est réalisé par gravure sèche.

6. Procédé selon l'une quelconque des revendications 1 à 3, **caractérisé en ce que** l'évidement (46, 47 ; 56, 57) est réalisé par usinage mécanique en utilisant une scie ou un faisceau laser.

7. Procédé selon l'une quelconque des revendications précédentes, **caractérisé en ce que**: la zone de fragilisation (43) est formée par implantation d'espèces atomiques.

8. Procédé selon l'une quelconque des revendications 1 à 6, **caractérisé en ce que** la zone de fragilisation (43) est fermée par une souche poreuse.

9. Procédé selon l'une quelconque des revendications 1 à 6, **caractérisé en ce que** la zone de fragilisation (43) est formée par une interface de liaison amovible,

10. Procédé selon la revendication 6 et la revendication 7, **caractérisé en ce que** l'évidement (46, 47) prévu dans le substrat source (4) est réalisé avant l'étape d'implantation, d'espèces atomiques,

11. Procédé selon l'une quelconque des revendications précédentes, **caractérisé en ce que** la couche à transférer (41) est constituée d'un matériau semi-conducteur.
